Europäisches Patentamt

European Patent Office

Office européen des brevets

(19)

(11) **EP 0 788 149 A1**

(12) **EUROPEAN PATENT APPLICATION**

(43) Date of publication:
06.08.1997 Bulletin 1997/32

(51) Int. Cl.⁶: **H01L 21/3205**

(21) Application number: 96300779.4

(22) Date of filing: 05.02.1996

(84) Designated Contracting States:
AT BE CH DE DK ES FR GB GR IE IT LI LU MC NL PT SE

(71) Applicant: **HITACHI EUROPE LIMITED**
**Maidenhead, Berkshire, SL6 8YA (GB)**

(72) Inventors:
• **Sato, Toshihiko**
**Cambridge, CB4 1YE (GB)**

• **Hasko, David**
**Haddenham, Cambridge CB6 3SU (GB)**
• **Ahmed, Haroon**
**Cambridge CB3 9HP (GB)**

(74) Representative: **Read, Matthew Charles et al**
**Venner Shipley & Co.**
**20 Little Britain**
**London EC1A 7DH (GB)**

(54) **Method of depositing nanometre scale particles**

(57) Nanometre scale particles (3) are deposited on a substrate (1,2) that provides receptor sites of a first polarity on its surface. The particles are provided with a surface charge of a second opposite polarity such that they are attracted to the receptor sites on the substrate and adhere to it at locations that are spaced apart as a result of an electrostatic repulsion force between adjacent particles. As a result, a monolayer of particles is formed with even spacing, for use in quantum electronic devices.

(c) Protonation of Amino groups and Gold colloidal partricle deposition

## Description

This invention relates to a method of depositing nanometre scale particles on a substrate and has particular but not exclusive application to the fabrication of quantum electronic devices such as single electron transistors and memory devices.

Quantum electronic devices which manipulate the flow of individual electrons, are known and reference is directed to W. Chen, H. Ahmed and K. Nakazato, Appl. Phys. Lett. vol. 66, 3383 (1995). These prior devices make use of so-called quantum dots which are conductive islands, constructed on the nanometre scale which exhibit the Coulomb blockade effect. By this effect, the charging energy of the island is greater than the surrounding thermal energy, so that once charged by the entry of a single electron, no further electrons can enter the dot until an electron leaves. Quantum electronics devices use this effect to manipulate single electrons entering and leaving a quantum dot, and typically consist of a metal or semiconductor quantum dot in which electrons are localised, dielectric tunneling barriers through which single electrons enter or leave, and electrodes which either electrostatically bias the dot or supply electrons to the dot through the barriers.

A general discussion of the Coulomb blockade effect for such a system is given in Hermann Grabert and Michel H. Devoret, "Single Charge Tunneling" (Plenum Press, New York, 1992) pp. 1 - 3. From this, it will be understood that there are two basic requirements for realising the Coulomb blockade effect in a single electron device, as follows:

$$E_c = e^2/2C \gg kT, \qquad (1)$$

$$R_T \gg R_K = h/e^2 \qquad (2)$$

where T is the device operation temperature, $R_T$ is a tunneling resistance, $R_K = h/e^2$ is the resistance quantum, and $E_c = e^2/2C$ is the energy required to place an electron at a localised electronic state in the dot. Here the capacitance C is defined as a constant that relates the energy of the localised state and its spatial event i.e. the geometrical shape of the charge distribution. The capacitance C is easily defined in the case of metal clusters, and is also definable in the case of semiconductor quantum dots. Reference is directed to M. Macucci, Karl Hess and G. J. Iafrate, "Electronic Energy Spectrum and the Concept of Capacitance in Quantum Dots", Phys., Rev. B, vol. 48, p. 17354 (1993).

It is desirable that a practical single electron device be operable at room temperature i.e. with T = 300°K. This implies from criterion (1) listed above that the capacitance C should be very small, namely $C \ll 3 \times 10^{-18}$ F.

The capacitance C can be designated as the sum of two different capacitances, as follows:

$$C = C_S + C_e$$

where $C_S$ is known as the self-capacitance and is constituted by the capacitance between the island and infinity. $C_e$ is the capacitance between the dot and the surrounding electrodes of the device. When the dot diameter becomes smaller than 10nm, the self-capacitance $C_S$ mainly determines the total capacitance C as it is much larger than the other capacitances $C_e$. Therefore, in order to ensure room temperature operation, the dot size should be reduced below 10nm. However, devices with a dot sin of less than 10nm cannot be fabricated readily using conventional electron beam lithography as this is smaller than the state of the art techniques can readily achieve.

It is known that nanometre scale particles can be prepared chemically, with diameters of less than 10nm, such as colloidal particles and molecular clusters. For example gold colloidal particles in citrate gold sols have been prepared in a size range from 2nm to 100 nm. Reference is directed to N. Uyeda, M. Nishino, and E. Suito, J. Colloidal and Interface Science, vol. 43, p. 181 (1973). Also, ligand-stabilised $Au_{55}$ clusters with a gold metal core size of 1.4 nm have been reported - see G. Schön and U. Simon, Colloid Plym. Sci., vol. 273, pp. 101-127 and pp. 202-218 (1995). One of the significant features of these materials is their well defined particle size distribution. In the case of non-dispersed colloidal Au particles as reported by Uyeda et al *supra*, the size distribution has a 10 % standard deviation. In the case of molecular clusters, the size distribution is determined at an atomic-scale accuracy. The average diameters of these nano-scale particles are determined by the parameters of the chemical reactions that form the particles, such as the volume ratios of starting material solutions etc. Since the particle formation reactions proceed spontaneously by adjusting the macroscopic reaction parameters, they are free of the size limitations that arise in conventional lithographic quantum dot fabrication.

A method of colloidal particle coating on metallic oxide surfaces has been known since the 1960's and reference is directed to R. K. Iller, Journal of Colloid and Interface Science, vol. 21, pp 569-594 (1966). Also, Au particle disposition on a metal oxide surface using a silane coupler was reported by A. Doron, E. Katz and I. Willmer, Langmur, vol. 11, pp 1313-1317 (1995). However, a problem with this technique was that particle coagulation occurred.

An object of the present invention is to provide a method of depositing nanometre scale particles on a substrate in a manner suitable for use in quantum effect electronic devices.

In accordance with the invention there is provided a method of depositing nanometre scale particles on a substrate, comprising providing receptor sites of a first electrical polarity for the particles on the surface of the substrate, and providing the particles with a surface charge of a second opposite polarity such that they are attracted to the receptor sites on the substrate, and adhere thereto at locations that are spaced apart as a result of the repulsion between adjacent particles on the substrate.

Thus, in accordance with the invention, the spacing between the particles over the substrate can lie within a predetermined dimensional range. As is explained hereinafter, the inter-particle distance can be adjusted so as to permit control of the inter-particle distances which changes the probability of electrons tunneling from particle to particle.

Also, the invention permits the particles to be deposited at least substantially in a monolayer, which facilitates incorporation of the particles into an electronic device, e.g. with a lateral structure. In one example of the invention, to be described in more detail hereinafter, a solution of nano-scale particles, on which organic surfactant molecules are adsorbed, is used as a source of quantum dot materials. The substrate is treated with an organic surfactant to provide the receptor sites for the particles on the substrate.

In an aqueous solution, the surfactants on the particle surface are ionised, giving rise to an electrical charge on the surface of the nano-scale particle. By immersing the surfactant-treated substrate in the particle solution, the surfactant on the substrate surface is also ionised, giving rise to a charge on the surface of the substrate. By choosing an appropriate kind of surfactant, it is possible to give the substrate a charge which is opposite in polarity to that of the charge on the particle surface. Therefore, the particles are attracted towards the substrate due to the electro-static force between the two oppositely charged surfaces. After being coated with a monolayer of the particles, the charge on the substrate is neutralised, stopping further particle attraction. As a consequence, the substrate surface is coated with a monolayer of particles as does not have a tendency to form a multilayer configuration.

An electrostatic force is also present between the nano-scale charged particles that are attracted to the surface. The force between the particles is repulsive causing the particles to maintain a mutual separation. Since the monolayer deposition process proceeds without disturbing the colloidal suspension significantly, the particles reach the surface of the substrate individually, without suffering coagulation or flocculation. The inter-particle distance is determined by the balance between the repulsive force between the particles, and the attractive force between the particles and the substrate. As a consequence, it is possible to adjust the average inter-particle distance by changing the amount of charge on the particles or the charge density on the substrate surface. This adjustment of the charges can be done by changing the particle surface area (the particle diameter) assuming the surface charge densities on the particles are fixed, or by changing the amount of ionisation in the surfactant molecules.

The monolayer formation process proceeds spontaneously at the substrate-solution interface, realising a deposition method which is free from the resolution limitations arising from conventional nano-fabrication lithographic and e-beam techniques.

In one example of the invention, the nanometre scale particles are formed of Au, held in a colloidal suspension, with surface adsorbed citrate ions. The substrate may include an insulating surface, and is typically formed of silicon, with a $SiO_2$ surface layer, and is treated with a coupling agent that comprises an organosilane such as 3-(2-aminoethlyamino) propyltrimethoxysilane, (APTS).

The method of the invention can be used to form a region including quantum dots for a quantum electronic device. For example, the deposited nano-scale particles can be formed in a predetermined area by a mask patterning technique. The exposed area may define an elongate channel for single electron conduction between particles deposited therein. A source and drain region for the channel may be formed on the substrate. A gate region may also be provided for controlling conduction along the channel between the source and drain regions. The gate region may be provided to one side of the channel or alternatively, the gate region may overlie the channel, in which case an organic electrically insulating layer may be deposited over the particles in the channel, underneath the gate region .

In another device, the deposited quantum dots may define an array of spaced cells for use in the memory array. Data may be written and read from the cells using a probe such as an atomic force microscope. Extremely small memory elements can be provided in this manner, which may have dimensions of the order of 20 x 20 nm.

In order that the invention may be more fully understood, embodiments thereof will now be described by way of illustrative example with reference to the accompanying drawings in which:

*Figure 1a* is a schematic sectional view of a $SiO_2$ substrate;
*Figure 1b* is a sectional view of the substrate after having been treated with an organo-silane coupling agent;
*Figure 1c* is a schematic sectional view of the particle deposition process;
*Figure 2* is a graph illustrating the distance between the deposited particles as a function of particle diameter;
*Figure 3* is a schematic enlarged plan view of the substrate illustrating the regular spacing of the deposited nano-scale particles;
*Figure 4a, b and c* are corresponding sectional views that illustrate the process steps for applying the coupling agent to the substrate in a predetermined masked area;
*Figure 5* is an enlarged schematic plan view of a side gated transistor structure that includes a channel with deposited nano-scale particles for single electron transport;
*Figure 6a* is a schematic plan view of a similar device to that shown in Figure 5, but with an overlying gate structure;

*Figure 6b* is a sectional view through the device shown in Figure 6a, taken along the line a-a';

*Figure 6c* is an enlarged view of part of Figure 6b, showing insulating ligand molecules that act as an insulating layer, attached to the deposited nano-scale particles in the channel;

*Figure 7a* is a schematic plan view of a memory device incorporating elements of nano-scale deposited particles produced by the method according to the invention;

*Figure 7b* shows the memory device in section, together with an AFM probe tip for reading and writing data;

*Figure 7c* is an enlarged view of the configuration shown in Figure 7b; and

*Figures 8a to d* illustrate the energy levels in the device of Figure 7, during a reading and writing operation.

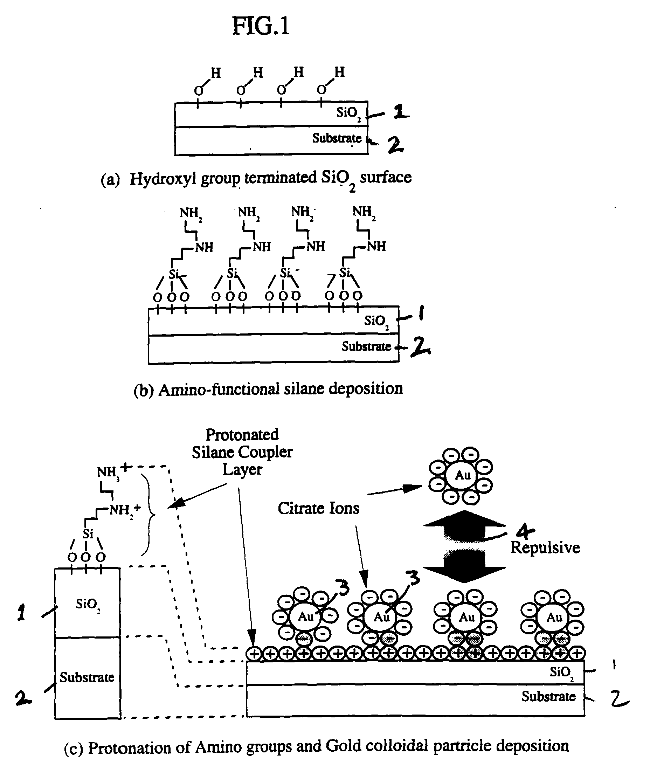

In the example of the method according to the invention to be described, gold particles with a nominal diameter of 10nm and a standard deviation in diameter of 1nm ($\simeq$ 10 %) are deposited onto a 1-micron thick $SiO_2$ film 1 thermally grown on an Si crystal substrate 2 shown in Figure 1.

The gold nano-scale particles can be prepared as described in Uyeda et al *supra* by a precipitation method, by mixing a solution of $HAuCl.4H_2O$ and sodium citrate. The diameter of the nano-scale deposited particles is dependent upon the concentration of the two solutions. The mixing of the solutions is performed at room temperature. The resulting precipitate comprises nano-scale Au particles with surface adsorbed citrate ions. Colloidal suspension of such particles can be purchased commercially, with predetermined mean particle sizes and diameter range distributions, from Nanoprobes Inc, 25E Loop Road Ste. 124, Stony Brook, NY 11790-3350 USA. The particles are supplied in an aqueous suspension. The adsorbed citrate ions give a negative charge to the Au particles.

Considering now the substrate shown in Figure 1a, it is initially cleaned using acetone and iso-propyl alcohol together with ultrasonic agitation, followed by oxygen plasma ashing. The substrate is then immersed in a dilute water solution of a coupling agent which, as will be described hereinafter, prepares the surface of the substrate so that the Au particles will attach themselves in a monolayer with uniform spacing. In this example, the coupling agent comprises an amino-functional silane. The substrate was immersed in a dilute water solution of APTS (0.05% [ v/v]) for five minutes. Then the samples were removed from the solution, dried with a nitrogen gun and baked for 30 minutes at 120°C in an oven.

The commercially purchased Au citrate sol was dialysed and re-suspended in pure water prior to use. The APTS treated-substrate 1 was then immersed in the citrate Au sol for three hours. After immersion, the substrate was removed from the sol, and dried with the nitrogen gun to eliminate the solution.

The adsorption mechanism of the silane coupling agent to the $SiO_2$ surface has been extensively studied and is described in K. C. Vrancken, P. Van Der Voort, K. Grobert, and E. F. Vansant, in Chemically Modified Surfaces, edited by J. J. Pesek, I. E. Leigh (The Royal Society of Chemistry, Cambridge, 1994) pp. 46-57. It is well known that the $SiO_2$ surface 1 is terminated by hydroxyl groups when exposed to the atmosphere, as is shown in Figure 1a. The adsorbed hydroxyl group density is typically at the level of 5 molecules per $nm^2$. The amino-functional silane molecules of the coupling agent, become connected to these hydroxyl-group sites, as shown in Figure 1b. The amino-functional silanes are hydrolysed in an aqueous solution and form hydrogen bonds with the surface 1, assisted by the water molecules. After this physisorption, direct condensation (chemisorption) of the silane takes place, due to the catalytic effect of the amino group, forming siloxane bonds with the substrate silicon. As a consequence, the APTS molecules are oriented with their free amino groups away from the substrate as shown in Figure 1b. When the silane treated sample is immersed in the citrate Au sol, the amino groups are protonated, giving a positive surface charge to the substrate as shown in Figure 1c. The negatively charged Au particles 3 are attracted and deposited onto the positively charged substrate surface. After being coated with a monolayer of Au particles, the charge on the $SiO_2$ surface 1 becomes neutralised which inhibits further layers of particles from arriving at becoming deposited on the surface, as shown schematically by arrow 4 is Figure 1c. Thus, only a monolayer is formed.

The negative surface charges of the Au particles cause adjacent particles to repel one another electrostatically and as a result, irregular inter-particle spacing is established in the monolayer.

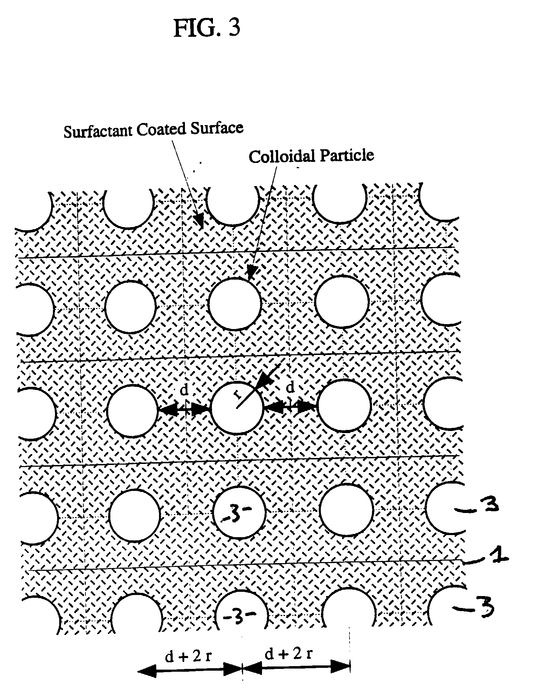

The inter-particle distances are determined by the charge neutrality condition between the positive charge induced by the protonation of the amino groups and the negative charge brought in by the citrate ions adsorbed on the Au particles. Referring to Figure 3, in order to estimate the particle spacing, it is assumed that each Au particle sits at the centre of a square area on the substrate surface. Each particle has a radius $r$, and $d$ designates the distance between adjacent particles on the substrate. The surface charge density $Q_s$ and $Q_p$ are assumed to be uniform over the areas of the substrate and the particles respectively. For the purposes of this analysis, the particle radius $r$ is assumed to be constant. In this situation, the charge neutrality condition can be written as:

$$Q_s(d + 2r)^2 = 4 \pi \, r^2 \, Q_p, \qquad (3)$$

where the right-hand side expresses the charge on the square area on the substrate, are the left-hand side is the charge on the particle. From this equation, the inter-particle distance $d$ can be expressed as:

$$d = 2r \left\{ \pi \, (Q_p/Q_s)^{1/2} - 1 \right\} \qquad (4)$$

The eq. (4) shows that the inter-particle distance $d$ linearly depends on the particle radius if the surface charge densities are fixed.

Further, the surface density of the silane coupler when adsorbed onto metal oxide surfaces is known to be of the order to $10^{-18} \, m^{-2}$, from Doron et al *supra*. Also, the surface density of the citrate ions on Au colloidal particles has been reported to be $3 \times 10^{-18} \, m^{-2}$ as described in M. Mabuchi, T. Takenaka, T. Fujiyoshi and N.Uyeda, Surface Science, vol. 119, p. 150 (1982). Since these values are close to each other, the ratio $Q_p/Q_s$ may be approximated as:

$$Q_p/Q_s \sim 1. \qquad (5)$$

Inserting equations (5) into eq. (4),

$$d \sim 2r \qquad (6)$$

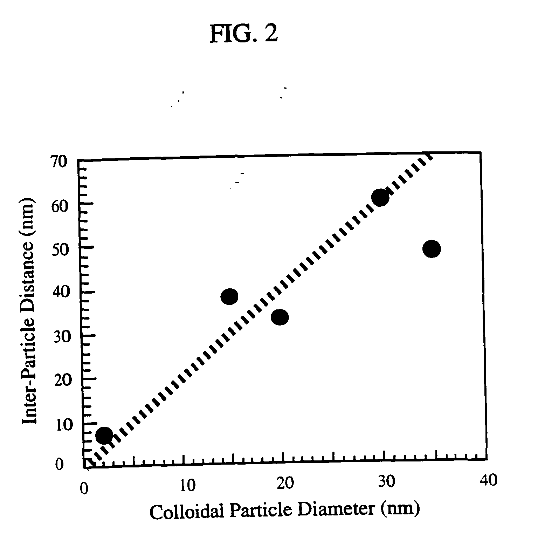

Equation (6) indicates that the inter-particle distance $d$ is of the order of the diameter of the Au colloidal particle. This relationship is consistent with the result of SEM observation as plotted in the graph of Figure 2. The dashed line in Figure 2 indicates the relationship given by equation (6).

The method according to the invention is also applicable to other colloidal particles including metals such as Au, Ag, Pd, Pt, Ti, Cu, Cd, Hg, Al, Ni etc, metal oxides such as $SiO_2$, $Al_2O_3$, $NiO$, $TiO_2$, etc and also to semiconductor particles such as Si, CdS, CdSe, etc.

Also, by attaching appropriate organic surfactants onto ligand-stabilised $Au_{55}$ clusters, a charge can be given to the clusters and the deposition method is also applicable to such cluster material. For formation of such material, reference is directed to Schön et al *supra*.

The silane coupling agent can be chosen from a variety of organo-silanes with different functional groups. For example, 3-aminopropyltrimethoxysilane and 3-[2-(2-aminoethylamino)ethylamino]propyl-trimethoxysilane can be used in almost the same way as the APTS. Since the number of amino groups incorporated in those silane coupler molecules are different, they give slightly different inter-particle distances reflecting the differences in the substrate surface charge induced by those amino groups in the silane coupler molecules. Also, the charge polarity can be changed by replacing the amino group with other groups such as a carboxyl group (-COOH) that dissociates in a water solution leaving a negative charge in the form of $-COO^-$. In this case, the charge polarity on the particles is changed accordingly.

Furthermore, the long chain n-alkanethiol $(HS(CH_2)_n X$, $X = COOH$, $CH_2NH_3$, etc) can also be used as the agent of particle substrate adhesion with an appropriate combination of substrate materials. These surfactant materials exhibit highly-ordered monolayer formation on an Au film deposited substrate surface. This is described in more detail in R. G. Nuzzo, L. H. Dubois, and D. L. Allara, J. Am. Chem. Soc., vol. 112, pp. 558-569 (1990). By choosing an appropriate functional group X as a tail group, it is possible to generate a surface charge in the similar way to the silane couplers.

Changing the surfactant molecule has another effect on the properties of tunneling barriers presented by the deposited particles (described in more detail hereinafter). The use of an alkanethiol with part of the units of alkane chain $(CH_2)$ replaced by $(CF_2)$ units for example, $HS(CH_2)_2(CF_2)_5CF_3$ increases the tunneling barrier height and the dielectric constant significantly because of the inductive effect of the fluorine atoms. This effect is described in more detail in E. E. Polymeropoulos and J. Sagiv, J. Chem. Phys. vol. 69, no. 5, pp. 1836 - 1847 (1987).

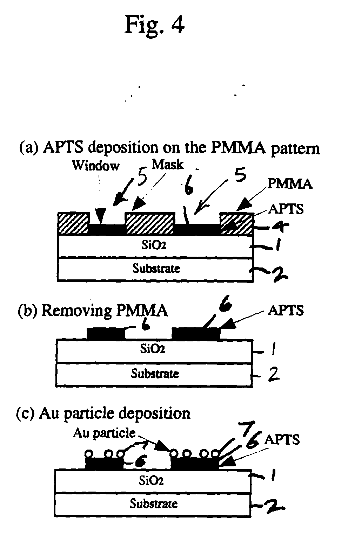

The resulting deposited monolayer of nanometre scale Au particles has particular application to quantum effect electronic devices. In order to deposit the monolayer in a predefined area of a device, a masking technique may be used, which will now be described with reference to Figure 4. The masking technique utilises conventional electron beam lithography.

The use of water as the solvent for APTS has the advantage that the described deposition method according to the invention can be used with conventional electron beam lithography. Most conventional resists are not soluble in water, so that the APTS deposition can be patterned using an electron beam resist.

Referring to Figure 4a, a conventional polymethylmethacrylate (PMMA) mask pattern 4 is deposited on the $SiO_2$ surface 1 as shown in Figure 4a. Windows 5 are opened in the layer 4 so as to expose areas of the $SiO_2$ layer 1. This is carried out by conventional electron beam radiation and development. The APTS silane coupling agent is then applied to the exposed areas in the windows 5. Then the PMMA together with the APTS that is not in contact with the $SiO_2$, is removed by immersion of the sample in an acetone bath for three hours and subsequent washing in further acetone and IPA, together with ultrasonic agitation. This results in a patterned APTS layer 6 as shown in Figure 4b. The sample is then immersed in the Au citrate sol in the manner previously described so that an Au particle monolayer 7 is produced corresponding to the mask pattern. For example, by this method, 2nm Au particles can be deposited selectively onto small APTS defined window of 10nm width, with the same surface coverage density of Au particles as for an unpatterned surface (i.e. $1 \times 10^{-12}$ particle.cm$^{-2}$).

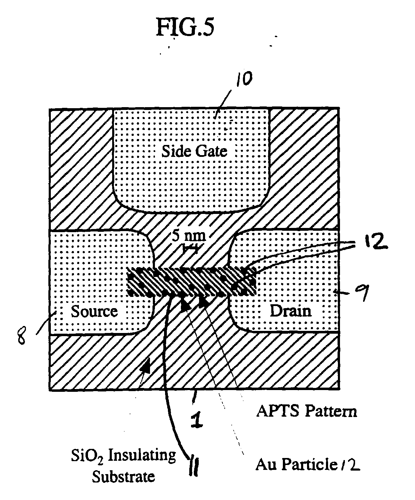

Figure 5 is a plan view of a lateral multiple junction single-electron device structure fabricated according to the method of the present invention. A $SiO_2$ insulating substrate 1 is formed with a source 8, drain 9 and side gate 10 by conventional metallisation techniques. A channel 11, formed by the technique described previously with reference to Figure 4, consists of an APTS treated region formed with an overlying Au particle monolayer, that contains Au particles, such as particle 12. A typical spacing between adjacent particles is 5nm. The width of the channel may be 10nm. In use, a potential difference is applied between the source 8 and drain 9, and electron transport occurs by single electron tunneling between adjacent particles 12 along the length of the channel 11, by means of the Coulomb blockade effect. The device can operate at room temperature due to the small size of the Au particles and their relative spacing. The voltage applied to the side gate 10 can control the rate of electron transport between the source and drain.

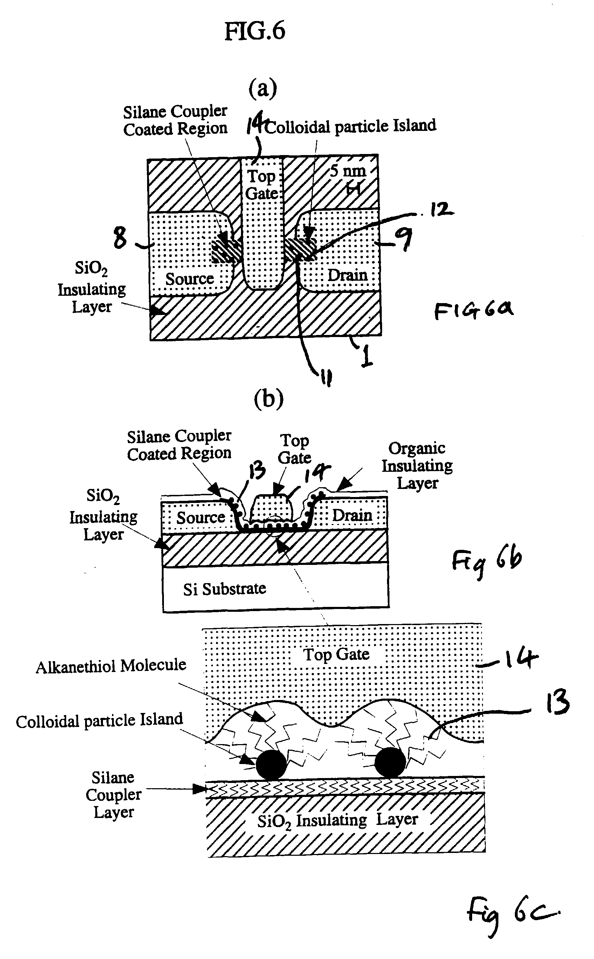

Figure 6 illustrates an alternative device configuration with a gate structure which overlies the channel 11. Like parts are marked with the same reference numbers. The device is fabricated by forming source and drain regions in the substrate 1 using conventional electron beam lithographic techniques and then a PMMA window with a width of 10nm is formed between the source and drain electrodes, so as to overlap them at its ends. Inside the window, 2nm Au particles are deposited using the silane coupling agent APTS and the PMMA pattern in then removed in the manner described generally with reference to Figure 4.

Thereafter, the Au particle monolayer is pre-treated with a boiling 2M solution of KOH for one hour, rinsed with water and immersed in concentrated sulphuric acid in order to remove the adsorbed citrate ions on the Au particles.

Then, an alkanethiol monolayer was deposited as an organic insulating layer. The deposition process was carried out by immersing the sample in an ethanol solution of 1 mM 1-octadecanethiol for 12 hours at room temperature. This forms an insulating layer 13 which can be seen in Figure 4b and also in the enlarged section of Figure 4c.

A top gate 14 was then formed to overlie the channel 11, between the source and drain 8, 9, by using conventional metallisation techniques and electron beam lithography.

The top gate structure of Figure 6 exhibits superior gate sensitivity as compared with the side gate device of Figure 5, by two orders of magnitude. The gate sensitivity can be further increased by reducing the thickness of the organic insulating layer 13. As can be seen from Figure 6c, thickness control can be achieved by choosing an alkanethiol with a shorter alkane chain length. For example by using a 1-decanethiol, the thickness is roughly halved because the number of carbon atoms in the chain is reduced from 17 (for 1-octadecanethiol) to 9 (1-decanethiol).

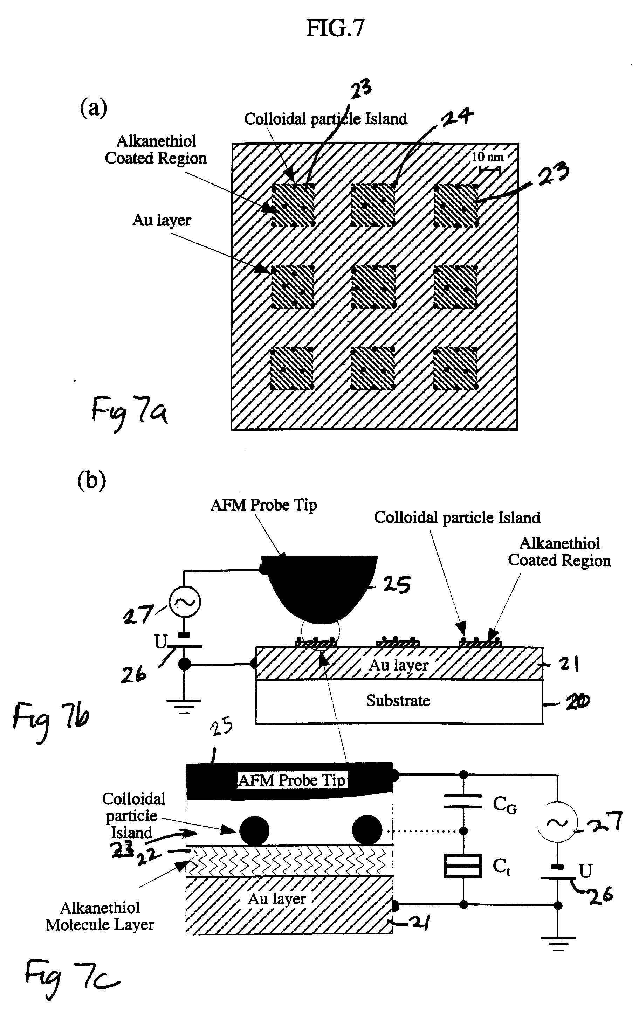

Referring now to Figure 7, an embodiment of the invention is shown, with a vertical structure which can be used as a high density single-electron memory device.

The device fabrication is carried out according to the following procedure:

Firstly, a substrate 20, typically a Si substrate, is coated with a 200 nm Au layer 21 by conventional vacuum evaporation techniques. Subsequently, a layer 22 of alkanethiol is deposited on the Au layer 21 from a 1mM ethanol solution, according to the principles described with reference to Figure 6.

Then the alkanethiol treated substrate is exposed to a 60 kV electron beam. The alkanethiol layer 22 is removed from the areas which are exposed to electron beam irradiation, so as to leave an array of 20 nm x 20 nm squares of alkanethiol coated regions separated at 30 nm intervals, as shown in Figure 7a. The self-development process of alkanethiol is described in R. C. Tiberio, H. G. Craighead, M. Lercel, T. Lao, C. W. Sheen and D. L. Allara, Appl. Phys. Lett., vol. 62, pp 476 - 478 (1993).

Inside the alkanethiol coated regions, a monolayer of Au particles of diameter 2nm is deposited by immersing the substrate into the previously described Au solution, in the manner previously described, and then the sample is cleaned. Thus, the matrix elements 23 are provided with a monolayer of Au particles such as 24, as shown in Figure 7a.

In order to investigate the characteristics of the device, it is loaded into an atomic force microscopy (AFM) device. The memory device stores one bit of information in the form of an excess electron for each particle or island 24. In order to produce the excess electronic charge, a metal coated AFM probe tip 25 is used for both reading and writing operations. As shown in Figure 7b, when the AFM probe tip 25 is brought into proximity with one of the elements 23, it forms a closed circuit consisting of a DC voltage source 26 that biases the probe tip, an AC modulation voltage 27, and a series connection of capacitances $C_t$ and $C_G$. The capacitance $C_t$ is constituted by the capacitance between the Au layer 21 and the element 23, separated by the insulating layer 22, whereas the capacitance $C_G$, comprises the capacitance between the element 23 and the AFM probe tip 25. Since the radius of the probe tip 25 is typically about 50 nm, all the Au particles within the element 23 of dimensions 20 x 20 nm come under the tip surface and form parallel capacitive connections.

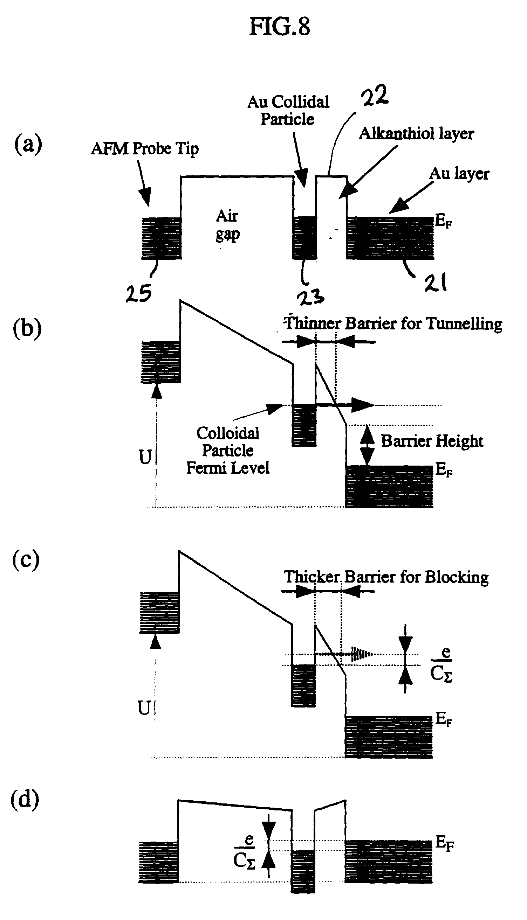

Figure 8 illustrates the writing operation for the device. In the writing operation, only the DC bias 26 is used. The starting condition is that the Fermi level of the Au particles e.g. particle 24, is aligned to that of the Au layer 21 for zero biasing voltage i.e. U = 0. This is shown in Figure 8a.

On application of a biasing voltage U, typically more than 5 volts, the Fermi level of the particle 24 is lifted up to a level at which tunneling of an electron can take place. The thickness of the alkanethiol barrier 22 is chosen to be thick enough to inhibit the electron tunneling until the particle Fermi level exceeds the barrier height and then field emission like tunneling from the particle to the Au layer 21 becomes possible, as shown in Figure 8b.

Immediately after the electron tunnels through the barrier, the particle 24 loses a charging energy of $e/C_\Sigma$,

where $C_{\Sigma} = C_t + C_G$. This energy relation is of the order of several milli-electronvolts in the case of a 2 nm Au particle 24. As a consequence, a significant lowering of the Fermi level takes place in the particle 24 as shown in Figure 8c. Therefore, an electron in the particle 24 sees a thicker barrier immediately after the first electron tunneling and thus, subsequent electron tunneling is inhibited.

By turning off the biasing voltage (or by removing the AFM probe tip from the element 23) the particle Fermi level is brought back to a level close to the Fermi level of the Au layer 21. However, because of the loss of the single electron from the particle 24, the Fermi level of the particle is lower than that of the Au layer 21 by $e/C_{\Sigma}$. By the same reasoning, the Fermi level of the particle 24 can be increased by an amount corresponding to one electron gain if an opposite biasing polarity is used.

The electron tunneling inhibition mechanism illustrated in Figure 8c is different from that of Coulomb blockade. In the present invention, it is the change of barrier thickness that switches electron tunneling rather than the availability of an electronic state on the Au layer 21 side of the tunneling barrier. This barrier is set by the thickness of the alkanethiol layer 22. This thickness can be controlled on an atomic scale and gives rise to improved controllability in accordance with the invention.

Because of the atomic-scale uniformity of the tunneling barrier thickness and also the uniformity in the particle size distribution of the Au particles 24, the capacitance $C_t$ is uniform for all of the particles 24 deposited on the alkanethiol layer 22. Therefore, in the writing process of Figure 8b, a single biasing voltage value U sets up a tunneling condition for all of the particles underneath the AFM probe tip. Thus, the charging of all the Au particles 24 in the an elemental area 23 takes place simultaneously, with each particle 24 being charged by one electron only.

The reading operation is performed by modulating the voltage applied to the AFM probe tip 25 by means of the source 27. The modulation voltage amplitude is chosen to be sufficiently small so that the charge accumulation in the particles 24 is not lost. The modulation of the tip voltage results in the modulation of the force felt by the AFM probe tip 25 itself, with the same frequency as that of the modulation frequency. This frequency component of the modulated force is proportional to the amount of charge deposited on the particle 24 in the element 23, during the writing process. This reading method has sufficient sensitivity to detect single electron charges. A more detailed description of the charge detection scheme using an AFM device is given in C. Shönenberger and S. F. Alvarado, Modern Phys. Lett. B, vol. 5, no. 13, pp 871-876 (1991). Since the average number of Au particles 24 in a 20 x 20 nm element 23 is about eight, the detection method gives a sufficient signal to noise ratio.

The described example of memory device has an exceedingly large information storage density because of the small size of the particles 24 and the small size of the elements 23. The density of integration however, is limited by the lateral resolution of the reading process and in particular, the dimensions of the AFM probe tip, namely 50 nm. Therefore, the 20 x 20 nm square 23 is arranged with a centre to centre interval of 50 nm, which in turn gives an information storage density of one bit per 50 x 50 nm area or $4 \times 10^{10}$ bits per cm$^2$.

## Claims

1. A method of depositing nanometre scale particles (3) on a substrate (1,2), comprising providing receptor sites of a first electrical polarity for the particles on a surface of the substrate, and providing the particles with a surface charge of a second opposite polarity such that they are attracted to the receptor sites on the substrate, and adhere thereto at locations that are spaced apart as a result of repulsion between adjacent particles on the substrate.

2. A method according to claim 1 wherein the particles (3) are deposited at least substantially in a monolayer.

3. A method according to claim 1 or 2 wherein the spacings ($d$) between adjacent deposited particles over the surface, lie within a predetermined dimensional range.

4. A method according to any preceding claim wherein the particles are provided with surface adsorbed ions of said second polarity.

5. A method according to claim 4 wherein said adsorbed ions are citrate ions.

6. A method according to any preceding claim wherein the particles are formed of a metal or an oxide thereof.

7. A method according to claim 6 wherein the particles are formed of Au, Ag, Pd, Pt, Ti, Cu, Cd, Hg, Al or Ni, or $SiO_2$, $Al_2O_3$, $NIO_2$ or $TiO_2$.

8. A method according to any preceding claim wherein the particles are formed of a semiconductor.

9. A method according to claim 8 wherein the particles are formed of Si, CdS or CdSe.

10. A method according to any preceding claim wherein the particles have a mean diameter of 10 nm or less.

11. A method according to claim 10 wherein the particles have a diameter of 2nm +/- 10%.

12. A method according to any preceding claim including treating the surface of the substrate with a coupling agent to provide the receptor sites for the particles.

13. A method according to claim 12 wherein the substrate has an insulating surface (1) and the coupling agent provides the receptor sites on the surface.

14. A method according to claim 12 or 13 wherein the substrate is of silicon, with a $SiO_2$ layer, that is treated with an organo-silane.

15. A method according to claim 14 wherein the organo-silane is an amino-functional silane.

16. A method according to claim 15 wherein the organo-silane comprises

3-(2- aminoethylamino)propyltrimethoxysilane or
3-aminopropyltrimethoxysilane or
3-[2-(2- aminoethylamino)ethylamino]propyltrimethoxysilane.

17. A method according to any one of claims 12 to 16 wherein the substrate is subjected to an aqueous suspension of said particles.

18. A method according to claim 17 including washing the substrate after treatment thereof with the coupling agent and before immersion thereof in the aqueous suspension of particles.

19. A method according to claim 18 including drying the washed substrate before immersion in the aqueous suspension of particles.

20. A method according to any one of claims 12 to 19 including providing a mask pattern (4) on the substrate, which exposes a predetermined area (5) of the surface, treating the exposed area with the coupling agent, and then removing the mask pattern.

21. A method according to claim 20 wherein the mask pattern is formed of PMMA and the exposed area is formed by electron beam exposure and development.

22. A method according to claim 20 or 21 wherein the exposed area defines an elongate channel (11) for single electron conduction between the particles deposited therein, and including providing source (8) and drain (9) regions at opposite ends of the channel.

23. A method according to claim 22 including providing a gate region (10,14) for controlling conduction along the channel between the source and drain regions.

24. A method according to claim 23 including providing the gate region (11) to one side of the channel on the substrate.

25. A method according to claim 23 including forming the gate region (14) to overlie the channel.

26. A method according to claim 25 including depositing an organic electrically insulating layer (13) over the particles in the channel, and then forming an electrically conductive layer (14) over the organic insulating layer whereby to provide the gate region.

27. A method according to any one of claims 22 to 26 wherein the channel region (11) has a width of the order of 10nm.

28. A method according to any one of claims 1 to 19 including forming a plurality of spaced elemental areas (23) of said deposited particles for use as memory elements.

29. A method according to any one of claims 1 to 19 including forming a conductive region (21) on the substrate (20), forming an insulating layer (22) over the conductive layer, and depositing said particles (24) on the insulating layer.

30. A method according to claim 29 including patterning the insulating layer (22) such that the particles become deposited on an array of elemental areas (23) for use in a memory array.

31. A method according to claim 30 including reading and writing charge to and from the elemental areas (23) with an external probe (25).

32. A method according to claim 28, 30 or 31 wherein the elemental areas each have dimensions of 20 x 20 nm

33. A device including a layer of nanometre scale particles produced by a method according to any preceding claim.

# FIG.1

(a) Hydroxyl group terminated $SiO_2$ surface

(b) Amino-functional silane deposition

(c) Protonation of Amino groups and Gold colloidal partricle deposition

FIG. 2

FIG. 3

Surfactant Coated Surface

Colloidal Particle

$$d + 2r \qquad d + 2r$$

# Fig. 4

(a) APTS deposition on the PMMA pattern

(b) Removing PMMA

(c) Au particle deposition

# FIG.5

# FIG.6

## (a)

Silane Coupler Coated Region

14 Colloidal particle Island

Top Gate

5 nm

SiO₂ Insulating Layer

Source

Drain

8

12

9

11

1

FIG 6a

## (b)

Silane Coupler Coated Region

Top Gate

13

14

Organic Insulating Layer

SiO₂ Insulating Layer

Source

Drain

Si Substrate

Fig 6b

Top Gate

14

Alkanethiol Molecule

13

Colloidal particle Island

Silane Coupler Layer

SiO₂ Insulating Layer

Fig 6c

## FIG.7

(a)

23
Colloidal particle Island
24
Alkanethiol
Coated Region
10 nm
23
Au layer

Fig 7a

(b)

AFM Probe Tip
Colloidal particle Island
Alkanethiol
Coated Region
25
27
U
26
Au layer — 21
Substrate — 20

Fig 7b

25
AFM Probe Tip
Colloidal
particle
Island
23 22
$C_G$
27
$C_t$
U
26
Alkanethiol
Molecule Layer
Au layer
21

Fig 7c

# FIG.8

(a)

Au Collidal
Particle

22

Alkanthiol layer

AFM Probe Tip

Au layer

Air
gap

$E_F$

25

23

21

(b)

Thinner Barrier for Tunnelling

Colloidal
Particle
Fermi Level

Barrier Height

U

$E_F$

(c)

Thicker Barrier for Blocking

$\dfrac{e}{C_\Sigma}$

U

$E_F$

(d)

$\dfrac{e}{C_\Sigma}$

$E_F$

European Patent
Office

**EUROPEAN SEARCH REPORT**

Application Number

EP 96 30 0779

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | ISRAEL JOURNAL OF CHEMISTRY, vol. 33, no. 1, 1993, ISRAEL, pages 53-58, XP000575118 C. LUANGDILOK ET AL.: "Size control and surface modification of colloidal semiconductor particles" | | H01L21/3205 |
| A | IBM TECHNICAL DISCLOSURE BULLETIN, vol. 37, no. 1, January 1994, NEW YORK US, pages 261-262, XP000428769 "Molecular brush assembly" | | |
| D,A | COLLOID & POLYMER SCIENCE, vol. 273, no. 2, February 1995, GERMANY, pages 101-117, XP000570059 G.SCHÖN ET AL.: "A fascinating new field in colloid science : small ligand-stabilized metal clusters and possible application in microelectronics" | | |

TECHNICAL FIELDS
SEARCHED     (Int.Cl.6)

H01L

The present search report has been drawn up for all claims

| Place of search | Date of completion of the search | Examiner |
|---|---|---|
| THE HAGUE | 3 July 1996 | Baillet, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)